# EUROPEAN PATENT APPLICATION

(11) **EP 1 182 711 A1**
(43) Date of publication of application: **27.02.2002**
(21) Application number: 01949067.1
(22) Date of filing: 30.01.2001
(51) Int. Cl.: H01L 33/00

(54) **LIGHT-EMITTING THYRISTOR MATRIX ARRAY**

(30) Priority: 31.01.2000 JP 2000022207
(71) Applicant: Nippon Sheet Glass Co., Ltd., Osaka-shi, Osaka 541-0041 (JP)
(72) Inventor: OHTSUKA, Shunsuke, Nippon Sheet Glass Co., Ltd., Osaka-shi, Osaka 541-0041 (JP); KUSUDA, Yukihisa, Nippon Sheet Glass Co., Ltd., Osaka-shi, Osaka 541-0041 (JP); OHNO, Seiji, Nippon Sheet Glass Co., Ltd., Osaka-shi, Osaka 541-0041 (JP); ARIMA, Takahisa, Nippon Sheet Glass Co., Ltd., Osaka-shi, Osaka 541-0041 (JP); SAITOU, Hideaki, Nippon Sheet Glass Co., Ltd., Osaka-shi, Osaka 541-0041 (JP); KURODA, Yasunao, Nippon Sheet Glass Co., Ltd., Osaka-shi, Osaka 541-0041 (JP)
(74) Representative: Wilson Gunn M'Caw
(86) International application number: JP0100595
(87) International publication number: WO0157934

(57) **Abstract**

The light-emitting thyristor matrix array may be provided in which wiring are crossed without being electrically connected to each other. An array of three-terminal light-emitting thyristors in which a substrate is used as a common cathode or anode is divided into blocks n by n (n is an integer≧2), gates of n light-emitting thyristors included in each block are separately connected to n gate-selecting lines, and anodes or cathodes of n light-emitting thyristors included in each block are commonly connected to one terminal, respectively.

## Description

### TECHNICAL FIELD

The present invention relates to a light-emitting thyristor matrix array, particularly to a light-emitting thyristor matrix array in which a wiring layout is implemented in such a manner that electrical short is not caused at portions where wirings are crossed.

### BACKGROUND ART

A light-emitting diode (LED) is generally used for a light-emitting element array in an optical print head an optical printer. In a light-emitting element array using LEDs, an array pitch of LEDs is determined by a critical pitch of wire bonding method, i.e. 500 dpi (dots per inch). Therefore, it is impossible to increase the resolution of a light-emitting element array by arraying LEDS at high density.

In order to resolve this problem, the applicant has already proposed a light-emitting element array using a three-terminal light-emitting thyristor of pnpn-structure, to which Japanese Patent has been issued (Japanese Patent No.2807910) that is incorporated herein by reference.

According to this patent, an array of three-terminal light-emitting thyristors in which a substrate is used as a common cathode is divided into blocks n by n (n is an integer ≧2), the gates of n light-emitting thyristors included in each block are separately connected to n gate-selecting lines, and the anodes of n light-emitting elements included in each block are commonly connected to one electrode, respectively. In this manner, the number of electrodes to supply signals for light emission may be decreased, so that an array pitch of light-emitting elements becomes smaller.

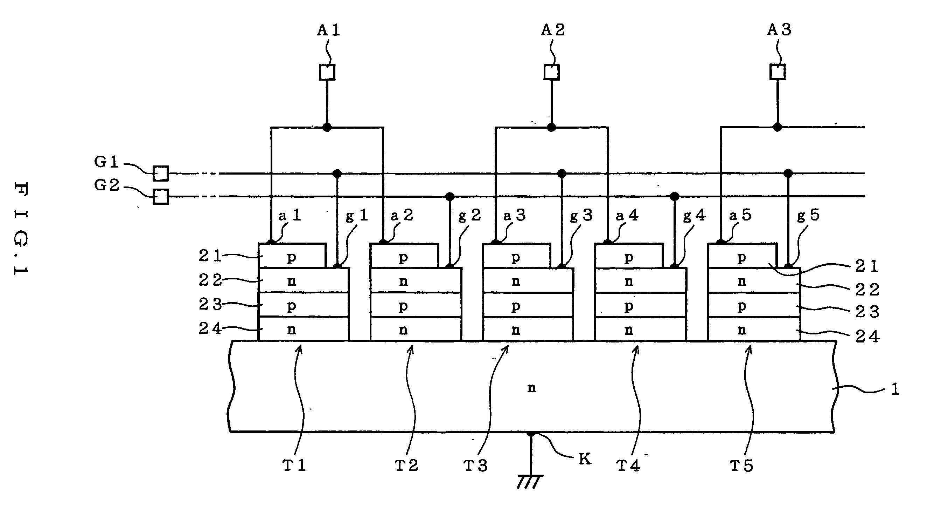

Fig.1 shows the structure of the light-emitting thyristor matrix array disclosed in the described above patent. Light-emitting thyristors T1, T2, T3, ··· are fabricated on an n-type semiconductor substrate 1, each consisting of pnpn-structure of an n-type semiconductor layer 24, a p-type semiconductor layer 23, an n-type semiconductor layer 22, and a p-type semiconductor layer 21. These thyristors are grouped into blocks two by two. Gate electrodes (g1, g2), (g3, g4), ··· of the light-emitting thyristors in each block are connected alternately to gate-selecting lines G1 and G2, and anode electrodes (a1, a2), (a3, a4), ··· of the light-emitting thyristors in each block are connected to anode terminals A1, A2, A3, ···, respectively. A cathode electrode K is provided on the bottom surface of the substrate 1.

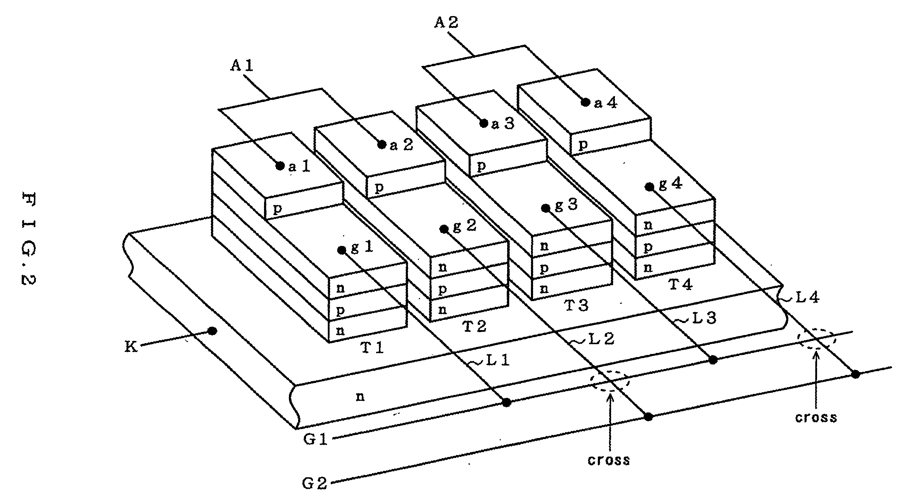

Fig.2 shows a perspective view of the light-emitting thyristor matrix array shown in Fig.1. It is recognized from the figure that wirings L2, L4, ··· from the gate electrodes g2, g4, ··· are intersected with the gate-selecting line G1.

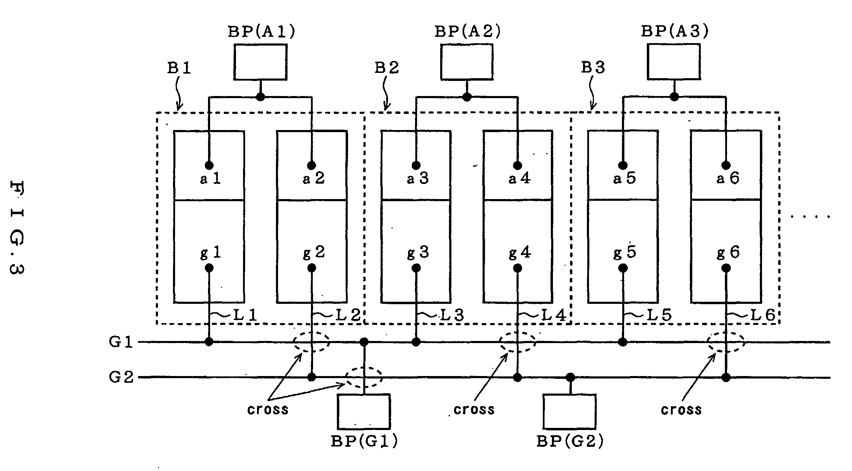

Fig.3 is a plan view of the light-emitting thyristor matrix array including bonding pads provided on both sides of an array of thyristors. In the figure, BP(A1), BP(A2), BP(A3), ··· designate the bonding pads for the terminal A1, A2, A3, ···, and BP(G1), BP(G2) for the gate-selecting lines G1 and G2. Also, B1, B2, B3, ··· denote blocks each including two light-emitting thyristors.

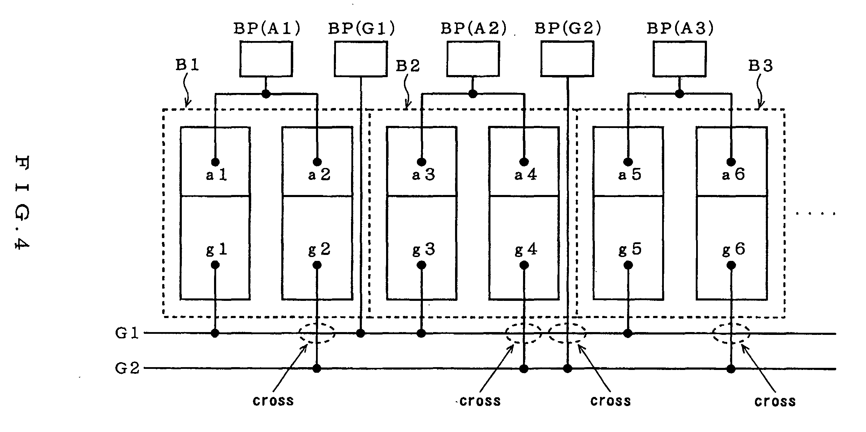

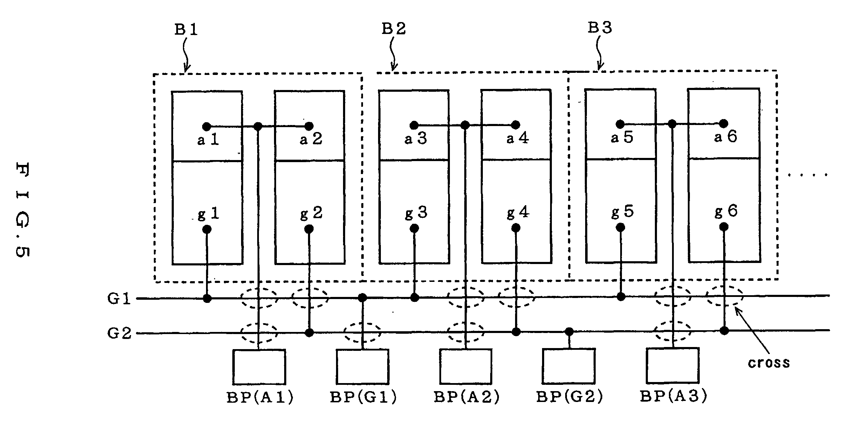

Figs.4 and 5 show examples in which bonding pads are provided on one side of an array of thyristors. In Fig.4, bonding pads are provided on the opposite side to the gate-selecting lines. In Fig.5, bonding pads are provided on the side of the gate-selecting lines.

As apparent from Figs.3-5, it is appreciated that a wiring layout such that wirings are crossed is necessarily caused in spite of arrangement of the bonding pads. Wirings should not be electrically shorted to each other, at portions where wirings are crossed.

### DISCLOSURE OF THE INVENTION

The object of the present invention is to provide the structure in which wirings are crossed without being electrically connected to each other in the conventional light-emitting thyristor matrix array.

The present invention is directed to a light-emitting thyristor matrix array is provided, wherein an array of three-terminal light-emitting thyristors in which a substrate is used as a common cathode or anode is divided into blocks n by n (n is an integer ≧ 2), gates of n light-emitting thyristors included in each block are separately connected to n gate-selecting lines, and anodes or cathodes of n light-emitting thyristors included in each block are commonly connected to one terminal, respectively.

According to a first aspect of the present invention, a wiring layout where wirings not to be electrically shorted are crossed is implemented by a two-layer wiring structure.

According to a second aspect of the present invention, a wiring layout where wirings not to be electrically shorted are crossed is implemented by utilizing gate electrode of the light-emitting thyristors as cross under wirings.

According to a third aspect of the present invention, bonding pads are arrayed in parallel with the array direction of the light-emitting thyristors and on one side of the array of the light-emitting thyristors, and a wiring layout where wirings to the bonding pads cross the gate-selecting lines is implemented by utilizing electrodes on islands isolated from the light-emitting thyristors as cross under wirings.

According to a forth aspect of the present invention, bonding pads are arrayed in parallel with the array direction of the light-emitting thyristors and on one side of the array of the light-emitting thyristors, and a wiring layout where wirings to the bonding pads cross the gate-selecting lines is implemented by utilizing gate electrode elongated around a light-emitting portion of the thyristor as a cross under wiring.

According to a fifth aspect of the present invention, bonding pads are arrayed in parallel with the array direction of the light-emitting thyristors and on one side of the array of the light-emitting thyristors, and a wiring layout where wirings to the bonding pads cross the gate-selecting lines is implemented by utilizing two gate electrode parts provided around a light-emitting portion of the thyristor as a cross under wiring, the two gate electrode parts being electrically connected by an underlying gate layer.

It should be noted that each of five aspects described above may be applicable to the light-emitting thyristor matrix array in which anodes or cathodes are connected to selecting lines.

### BRIEF DESCRIPTION OF THE DRAWINGS

Fig.1 is a diagram illustrating the structure of conventional light-emitting thyristor matrix array.
Fig.2 is a perspective view of the light-emitting thyristor matrix array shown in Fig.1.
Fig.3 is a plan view of the light-emitting thyristor matrix array in which bonding pads are provided on both sides of an array of thyristors.
Fig.4 is a plan view of the light-emitting thyristor matrix array in which bonding pads are provided on the opposite side to the gate-selecting lines.
Fig.5 is a plan view of the light-emitting thyristor matrix array in which bonding pads are provided on the side of the gate-selecting lines.
Fig.6 is a diagram illustrating a two-layer wiring structure.
Fig.7 is a plan view illustrating the structure using an electrode as a cross under wiring.
Fig.8 is a plan view illustrating the structure using a gate electrode formed on an isolated island as a cross under wiring.
Fig.9 is a cross-sectional view taken along x-y line in Fig.8.
Fig.10 is a cross-sectional view illustrating the structure using an anode electrode formed on an isolated island as a cross under wiring.
Fig.11 is a plan view illustrating the structure using a gate electrode elongated around a light-emitting portion of the thyristor as a cross under wiring.
Fig.12 is a plan view illustrating the structure using two gate electrode parts electrically conducted through a gate layer as a cross under wiring.
Fig.13 is a plan view illustrating the structure of the light-emitting element thyristor matrix array in which anodes are connected to selecting lines.

### BEST MODE FOR CARRYING OUT THE INVENTION

A preferred embodiment of a light-emitting thyristor matrix array according to the present invention will now be described with reference to the drawings.

### Embodiment 1

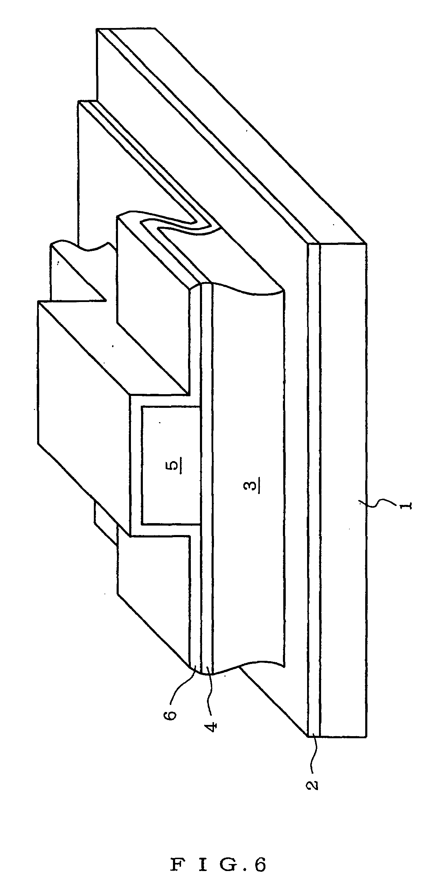

Fig. 6 shows a two-layer wiring structure to intersect wirings without being electrically shorted. According to the two-layer wiring structure, an underlying insulating film 2 of SiO₂ is provided on a substrate 1, on which first layer wirings 3 and second layer wirings 5 of Al are provided. An interlayer insulating film 4 of SiO₂ is provided between the first layer wirings 3 and the second layer wirings 5. The second layer wiring 5 is covered by a protective insulating film 6 of SiO₂.

The two-layer wiring structure is fabricated in a following manner. First, the underlying insulating film 2 is deposited on the entire surface of the substrate 1. Next, the first layer wirings 3 are formed on the underlying insulating film 2. Then, the interlayer insulating film 4 is deposited on the entire surface of the structure. Then, the second insulating wirings are formed on the interlayer insulating film 4. Finally, the protective insulating film 6 is deposited on the entire surface of the structure.

Contact holes are opened in the underlying insulating film 2 at the portions where the first layer wiring 3 is required to be electrically connected to electrodes or wiring formed prior to forming the two-layer wiring structure, and contact holes are opened in the interlayer insulating film 4 at the portions where the first layer wiring 3 is required to be electrically connected to the second layer wiring 5.

The two-layer wiring structure may be applicable to the wiring layout of the light-emitting thyristor matrix array shown in Fig.2 in such a manner that the wirings L1, L2, L3, ··· are assumed as the first layer wirings and the gate-selecting lines as the second layer wirings.

### Embodiment 2

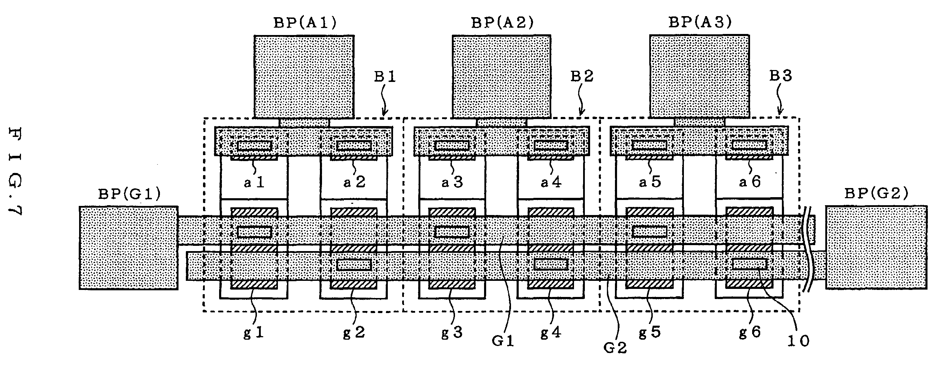

In the present embodiment, electrodes formed during single light-emitting thyristor is fabricated is utilized as cross under wirings, in order to implement a cross wiring layout. Fig.7 is a plan view illustrating the structure of the present embodiment.

Each of the gate electrodes g1, g2, g3, ··· of Al is elongated to utilize the elongated gate electrode as a cross under wiring. That is, the gate electrode is elongated in a direction perpendicular to the gate-selecting lines G1 and G2, and the gate electrode is connected via a contact hole 10 to the gate-selecting line at a wiring cross portion. In the case that the gate electrode is not required to be connected to the gate-selecting line, a contact hole is not formed at a wiring cross portion.

The light-emitting thyristor matrix array may be fabricated in a following manner. First, semiconductor layers of pnpn-structure are stacked on a semiconductor substrate. Next, anode electrode are formed on the topmost p-type semiconductor layer, and a part thereof is etched away to expose a gate layer. Gate electrodes are formed on the exposed gate layers. Then, element isolation is carried out by etching to form mesa-structures, followed by the deposition of an insulating film. Next, contact holes are opened in the insulating film, and gate selecting lines are formed so as to pass over the gate electrodes. Finally, a cathode electrode is formed on the bottom surface of the semiconductor substrate.

The process described above is the same as that for fabricating single light-emitting thyristor, and does not require further process to implement a cross wiring layout which is unique for the light-emitting thyristor matrix array.

Because the gate electrodes of the light-emitting thyristors are utilized as cross under wirings, the light-emitting thyristor matrix array having a cross wiring layout may be implemented by the same fabricating process as that of single light-emitting thyristor.

According to the present embodiment, an inexpensive light-emitting thyristor matrix array may be provided because a fabricating process is not increased in comparison with the embodiment 1 utilizing the two-layer wiring structure. An area required for the matrix array becomes smaller compared with the embodiment 1 which requires a wiring forming area for the two-layer wiring structure. Therefore, the number of the light-emitting thyristor matrix array chips obtained from one wafer is increased, resulting in the decrease of a manufacturing cost.

### Embodiment 3

This embodiment may be applicable to the light-emitting thyristor matrix array in Fig.5 wherein all the bonding pads are positioned on one side of an array of thyristors. The reason why all the bonding pads are positioned on one side of an array of thyristors is to decrease an area occupied by a light-emitting thyristor matrix array chip and to realize the reduction of a manufacturing cost.

For such structure of the light-emitting thyristor matrix array, the present embodiment utilizes the same manufacturing process as that of single light-emitting thyristor and intends to implement the structure to intersect the wirings without electrically shorting to each other when the gate-selecting lines are connected to bonding pads via wirings.

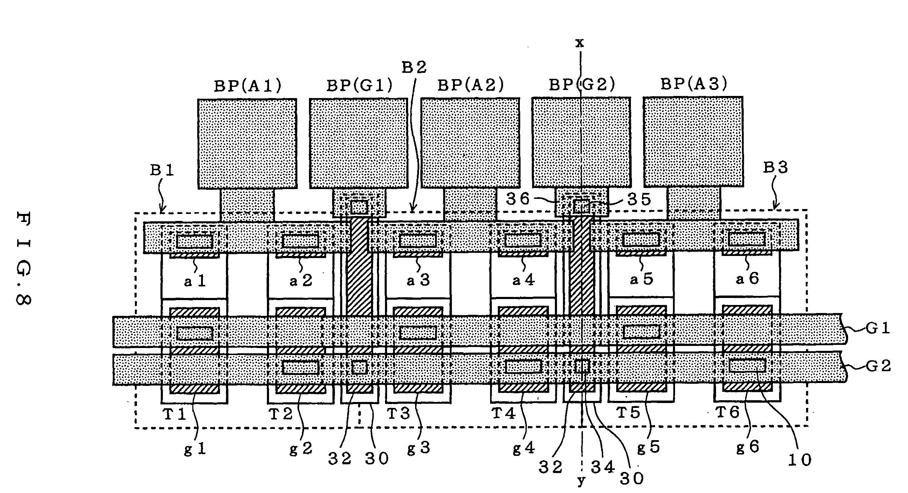

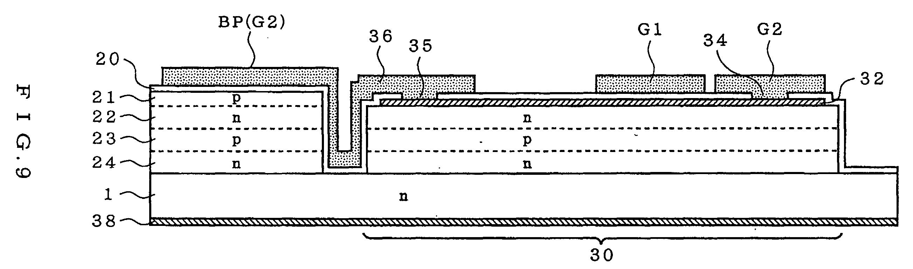

Figs.8 and 9 show the light-emitting thyristor matrix array according to the present embodiment. Fig.8 is a plan view and Fig.9 a cross-sectional view taken along x-y line in Fig.8.

Gate islands 30 are formed between the thyristors T2 and T3, and between the thyristors T4 and T5, with each gate island being isolated from the thyristors, respectively. A gate electrode 32 is formed on a gate layer of the gate island 30. The gate electrode 32 is elongated to cross the gate-selecting lines G1 and G2, and is electrically connected to the gate-selecting line G1 or G2 through a contact hole opened in an insulating layer. One end of the gate electrode 32 toward bonding pads is electrically connected to an Al wiring 36 through a contact hole 35 opened in the insulating layer. The Al wiring 36 is conducted to the bonding pad BP(G1) or BP(G2). In this manner, a cross wiring layout may be implemented in which the gate electrode isolated from the light-emitting thyristors is utilized as a cross under wiring.

The light-emitting thyristor matrix array having the structure described above may be fabricated in a following manner. First, a pnpn-structure consisting of an n-type semiconductor layer 24, a p-type semiconductor layer 23, an n-type semiconductor layer 22 and a p-type semiconductor layer 21 is stacked on a semiconductor substrate 1. Next, anode electrodes a1, a2, a3, ···· are formed on the topmost p-type semiconductor layer 21, and a part thereof is etched away to expose the n-type semiconductor layer 22 (a gate layer). Gate electrodes 32 are formed on the exposed gate layers 22. Then, an etching process is carried out to isolate the light-emitting thyristors T1, T2, T3, ··· and the gate islands 30 in mesa-structure. Then, the insulating film 20 is deposited on the entire surface of the structure. Next, the contact holes 10, 34 and 35 are opened in the insulating film 20, and the gate-selecting lines G1, G2, the Al wiring 36 and the bonding pads BP are formed. Finally, a cathode electrode 28 is formed on the bottom surface of the substrate 1.

The process described above is the same as that for fabricating single light-emitting thyristor, and does not require further process to implement a cross wiring layout which is unique for the light-emitting thyristor matrix array.

While the gate electrode is formed on the gate layer of the gate island in the structure described above, the gate electrode may be formed on any isolated island. For example, the gate electrode may be formed on the topmost anode layer or on the bottom of the isolation trench.

While the gate electrode is utilized as a cross under wiring in the structure described above, the anode electrode on the anode layer may be used. In this case, it is enough for the anode electrode to be formed on an isolated island, as in the case of gate electrode.

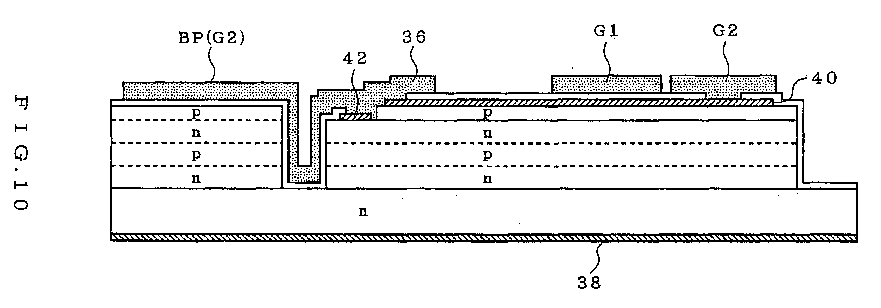

When the anode electrode formed on the anode layer is used as a cross under wiring, a parasitic thyristor is generated under the cross under wiring. In order to prevent the parasitic thyristor from generating, it is possible that the anode electrode 40 and the gate electrode 42 on the same isolated island are electrically shorted by the Al wiring 36 as shown in Fig.10.

While the cross under wirings are formed between the light-emitting thyristors T2 and T3, and between T4 and T5 in the structure described above, it is possible to form them any between T(n) and T(n+1).

While the bonding pads are positioned on the opposite side to the gate-selecting lines G1 and G2 in the structure described above, it is possible to position the bonding pads on the side of the gate-selecting lines G1 and G2 by deriving the wirings to the bonding pads outside the lines G1 and G2 using cross under wirings.

According to the present embodiment, all the bonding pads may be easily positioned on one side of an array of light-emitting thyristors. Therefore, it is possible to decrease an area occupied by a light-emitting thyristor matrix array chip and to realize the reduction of a manufacturing cost per chip. A cross wiring layout, which is caused when all the bonding pads are positioned on one side of an array of thyristors, may be implemented by the same process as that of single light-emitting thyristor, so that a manufacturing cost may be reduced in comparison with the embodiment which requires the two-layer wiring structure.

### Embodiment 4

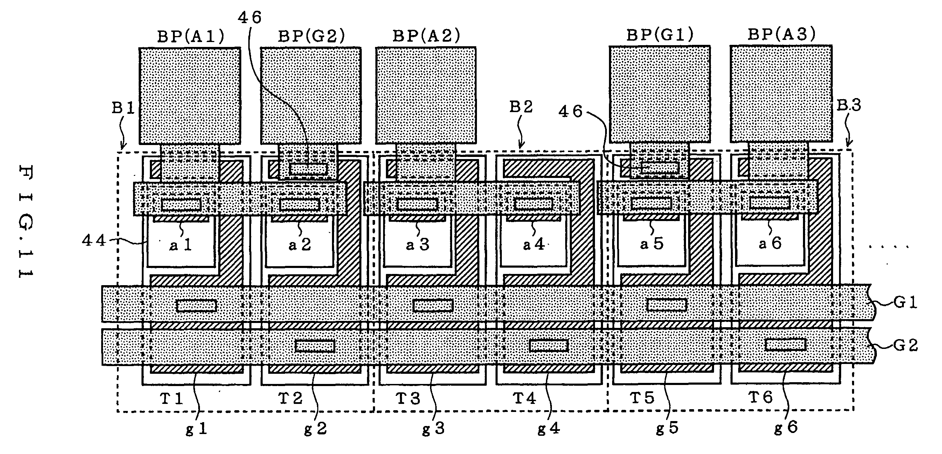

This embodiment is directed to another structure applicable to the light-emitting thyristor matrix array with all the bonding pads being positioned on one side of an array of thyristors, in a similar to the embodiment 3. Fig.11 shows a plan view of the structure. According to this structure, each of the gate electrodes g1, g2, g3, ··· of the light-emitting thyristors is elongated around a light-emitting portion 44 of the thyristor. The structure in which the gate electrodes g1, g2, g3, ··· are connected to the gate-selecting line G1 or G2 is the same as that in the embodiment 3. The connection between the gate-selecting lines G1, G2 and the bonding pads BP(G1), BP(G2) is implemented by connecting the bonding pad through a contact hole 46 to the part of the gate electrode elongated around the light-emitting portion 44. That is, the gate electrode g2 of the thyristor T2 is connected to the bonding pad BP(G2), and the gate electrode g5 of the thyristor T5 is connected to the bonding pad BP(G1).

While the shape of the gate electrode elongated around the light-emitting portion is that a part thereof is opened, the shape completely surrounding the light-emitting portion may be adopted.

### Embodiment 5

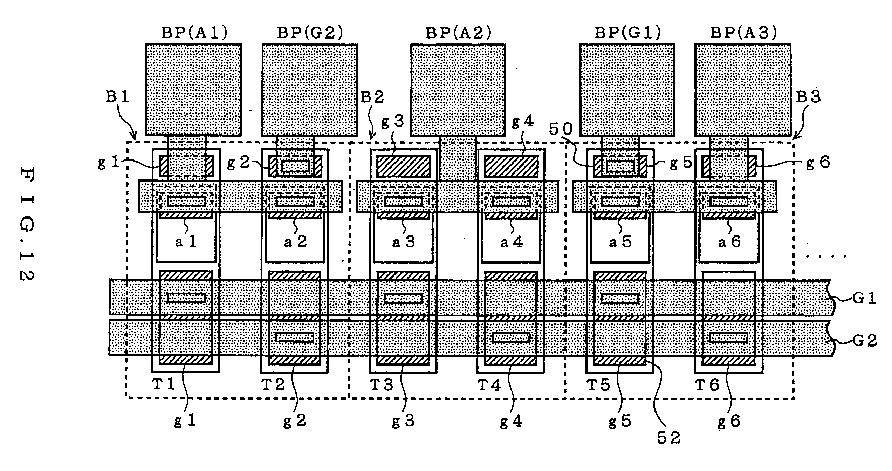

This embodiment is directed to still further structure applicable to the light-emitting thyristor matrix array with all the bonding pads being positioned on one side of an array of thyristors, in a similar to the embodiment 3 and 4. Fig.12 shows a plan view of the structure. According to this structure, the gate electrode is divided into two parts sandwiching the light-emitting portion 44, i.e. one part on the side of the bonding pads and the other part on the side of the gate-selecting lines. These two gate electrode parts are electrically connected via the underlying gate layer.

In Fig.12, the gate electrode part 50 is connected to the bonding pad BP(G1) through a contact hole, and the gate electrode part 52 is connected to gate-selecting line G1 through a contact hole, so that he bonding pad BP(G1) is electrically connected to the gate-selecting line G1. In a same manner, the bonding pad BP(G2) is electrically connected to the gate-selecting line G2.

According to the structure described above, signals from the bonding pads G1 and G2 are transferred to the gate-selecting lines G1 and G2 through the gate layer. In this structure, it is also possible that a high'resolution light-emitting thyristor matrix array may be easily implemented compared with the embodiment 3 in which the isolated gate islands are required.

### Embodiment 6

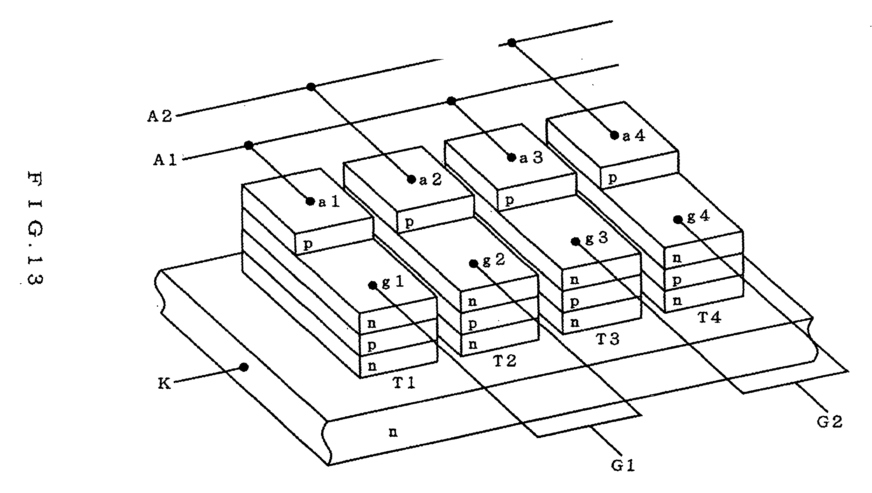

While the structure to which the light-emitting thysitor matrix array in Fig.2 is applicable is illustrated with reference to the embodiments 1-5, the present invention may be applied to the light-emitting matrix array in which anodes or cathodes are connected to selecting lines. Fig.13 shows a light-emitting thyristor matrix array in which cathodes are connected to selecting lines. Thyristors T1, T2, T3, ··· are grouped into blocks two by two. Anode electrodes (a1, a2), (a3, a4), ··· of the light-emitting thyristors in each block are connected alternately to anode-selecting lines A1 and A2, and gate electrodes (g1, g2), (g3, g4), ··· are connected to gate terminals G1, G2, G3, ···, respectively.

It would be apparent for those who skilled in the art that the structure of the embodiments described hereinbefore may be applicable to the light-emitting thyristor array in Fig.13.

### INDUSTRIAL APPLICABILITY

According to the present invention, the light-emitting thyristor matrix array may be provided in which wirings are crossed without being electrically connected to each other, the light-emitting thyristor matrix array having such a structure that the light-emitting thyristors is divided into blocks n by n, gates of light-emitting thyristors included in each block are separately connected to gate-selecting lines, and anodes or cathodes of light-emitting thyristors included in each block are commonly connected to one terminal, respectively.

## Claims

1. A light-emitting thyristor matrix array wherein an array of three-terminal light-emitting thyristors in which a substrate is used as a common cathode or anode is divided into blocks n by n (n is an integer ≧ 2), gates of n light-emitting thyristors included in each block are separately connected to n gate-selecting lines, and anodes or cathodes of n light-emitting thyristors included in each block are commonly connected to one terminal, respectively, **characterized in that** :
a wiring layout where wirings not to be electrically shorted are crossed is implemented by a two-layer wiring structure.

2. A light-emitting thyristor matrix array wherein an array of three-terminal light-emitting thyristors in which a substrate is used as a common cathode or anode is divided into blocks n by n (n is an integer≧2), anodes or cathodes of n light-emitting thyristors included in each block are separately connected to n anode-selecting lines or cathode-selecting lines , and gates of n light-emitting thyristors included in each block are commonly connected to one terminal, respectively, **characterized in that** :
a wiring layout where wirings not to be electrically shorted are crossed is implemented by a two-layer wiring structure.

3. A light-emitting thyristor matrix array wherein an array of three-terminal light-emitting thyristors in which a substrate is used as a common cathode or anode is divided into blocks n by n (n is an integer≧2), gates of n light-emitting thyristors included in each block are separately connected to n gate-selecting lines, and anodes or cathodes of n light-emitting thyristors included in each block are commonly connected to one terminal, respectively, **characterized in that** :
a wiring layout where wirings not to be electrically shorted are crossed is implemented by utilizing gate electrodes of the light-emitting thyristors as cross under wirings.

4. A light-emitting thyristor matrix array wherein an array of three-terminal light-emitting thyristors in which a substrate is used as a common cathode or anode is divided into blocks n by n (n is an integer≧2), anodes or cathodes of n light-emitting thyristors included in each block are separately connected to n anode-selecting lines or cathode-selecting lines , and gates of n light-emitting thyristors included in each block are commonly connected to one terminal, respectively, **characterized in that** :
a wiring layout where wirings not to be electrically shorted are crossed is implemented by utilizing anode electrodes or cathode electrodes of the light-emitting thyristors as cross under wirings.

5. A light-emitting thyristor matrix array wherein an array of three-terminal light-emitting thyristors in which a substrate is used as a common cathode or anode is divided into blocks n by n (n is an integer≧2), gates of n light-emitting thyristors included in each block are separately connected to n gate-selecting lines, and anodes or cathodes of n light-emitting thyristors included in each block are commonly connected to one terminal, respectively, **characterized in that** :
bonding pads are arrayed in parallel with the array direction of the light-emitting thyristors and on one side of the array of the light-emitting thyristors, and
a wiring layout where wirings to the bonding pads cross the gate-selecting lines is implemented by utilizing electrodes on islands isolated from the light-emitting thyristors as cross under wirings.

6. The light-emitting thyristor matrix array of claim 5, wherein the electrodes on the islands isolated from the light-emitting thyristors are gate electrodes, anode electrodes, or cathode electrodes.

7. The light-emitting thyristor matrix array of claim 5, wherein the anode electrode or cathode electrode is utilized as the cross under wiring, the anode electrode or cathode electrode is electrically shorted to the gate electrode on the same isolated island.

8. A light-emitting thyristor matrix array wherein an array of three-terminal light-emitting thyristors in which a substrate is used as a common cathode or anode is divided into blocks n by n (n is an integer ≧ 2), gates of n light-emitting thyristors included in each block are separately connected to n gate-selecting lines, and anodes or cathodes of n light-emitting thyristors included in each block are commonly connected to one terminal, respectively, **characterized in that** :
bonding pads are arrayed in parallel with the array direction of the light-emitting thyristors and on one side of the array of the light-emitting thyristors, and
a wiring layout where wirings to the bonding pads cross the gate-selecting lines is implemented by utilizing gate electrode elongated around a light-emitting portion of the thyristor as a cross under wiring.

9. A light-emitting thyristor matrix array wherein an array of three-terminal light-emitting thyristors in which a substrate is used as a common cathode or anode is divided into blocks n by n (n is an integer≧2), gates of n light-emitting thyristors included in each block are separately connected to n gate-selecting lines, and anodes or cathodes of n light-emitting thyristors included in each block are commonly connected to one terminal, respectively, **characterized in that** :
bonding pads are arrayed in parallel with the array direction of the light-emitting thyristors and on one side of the array of the light-emitting thyristors, and
a wiring layout where wirings to the bonding pads cross the gate-selecting lines is implemented by utilizing two gate electrode parts provided around a light-emitting portion of the thyristor as a cross under wiring, the two gate electrode parts being electrically connected by an underlying gate layer.

10. A light-emitting thyristor matrix array wherein an array of three-terminal light-emitting thyristors in which a substrate is used as a common cathode or anode is divided into blocks n by n (n is an integer≧2), anodes or cathodes of n light-emitting thyristors included in each block are separately connected to n anode-selecting lines or cathode-selecting lines , and gates of n light-emitting thyristors included in each block are commonly connected to one terminal, respectively, **characterized in that** :
bonding pads are arrayed in parallel with the array direction of the light-emitting thyristors and on one side of the array of the light-emitting thyristors, and
a wiring layout where wirings to the bonding pads cross the anode-selecting lines or cathode-selecting lines is implemented by utilizing electrodes on islands isolated from the light-emitting thyristors as cross under wirings.

11. The light-emitting thyristor matrix array of claim 10, wherein the electrodes on the islands isolated from the light-emitting thyristors are gate electrodes, anode electrodes, or cathode electrodes.

12. The light-emitting thyristor matrix array of claim 11, wherein the anode electrode or cathode electrode is utilized as the cross under wiring, the anode electrode or cathode electrode is electrically shorted to the gate electrode on the same isolated island.
